# EUROPEAN PATENT APPLICATION

(11) **EP 0 767 491 A2**
(43) Date of publication of application: **09.04.1997**
(21) Application number: 96307208.7
(22) Date of filing: 02.10.1996
(51) Int. Cl.: H01L 21/60, H01L 21/336

(54) **Method of forming a contact**

(30) Priority: 05.10.1995 US 538977
(71) Applicant: SGS-THOMSON MICROELECTRONICS, INC., Carrollton Texas 75006-5039 (US)
(72) Inventor: Smith, Gregory C., Carrollton, Texas 75007 (US)
(74) Representative: Palmer, Roger

(57) **Abstract**

A split-poly method for forming a buried contact between two sidewall spacers, and the semiconductor structure formed according to such a method is disclosed, wherein: an implanted region is formed in an opening through a thin first polysilicon and dielectric formed over a surface of an active region of first conductivity type in a semiconducting body; sidewall spacers are formed at the edges of the opening; and second conductor is formed over the implanted region, the sidewall spacers, and the first polysilicon, and is patterned to form a gate. The contact of the gate and the implanted region is the buried contact.

## Description

The present invention relates to the field of integrated circuits, and is more specifically directed to forming buried contacts ("first contact") in integrated circuits.

A buried contact is a direct contact from polysilicon to a substrate. Buried contacts have been looked to in the semiconductor industry for the past twenty years as a way to make a contact between two active regions without increasing the number of levels of metallization, since the buried contact is formed using polycrystalline silicon. This provides an additional contact layer without requiring additional topography, because the polycrystalline layer is already present.

Buried contacts have become even more desirable as the trend to decrease chip size while increasing the density of components per unit area continues. This trend has lead to a decrease both in the linewidth of conductors and the spaces between them, making it advantageous to use more layers of conductors in the integrated circuit device, but limiting the routing flexibility at each particular metallization layer. Additionally, as device size and distances between device components get smaller, the capacitance associated with metal conductors increases, causing an increase in the circuit's internal RC delay, and thus slowing down the speed of the circuit.

Although buried contacts provide the advantages set forth above they have not been as used widely as desired because they have been difficult to implement since they require patterning the gate oxide. One method of implementing a buried contact is through a split-poly process. A split-poly process involves depositing a thin first polycrystalline layer over the gate oxide and then forming the opening through which the contact will be made. This is done so that the masking layer used in making the opening does not directly contact the gate oxide and contaminate it. A second polycrystalline layer is then deposited over the first polycrystalline layer and substrate exposed through the opening.

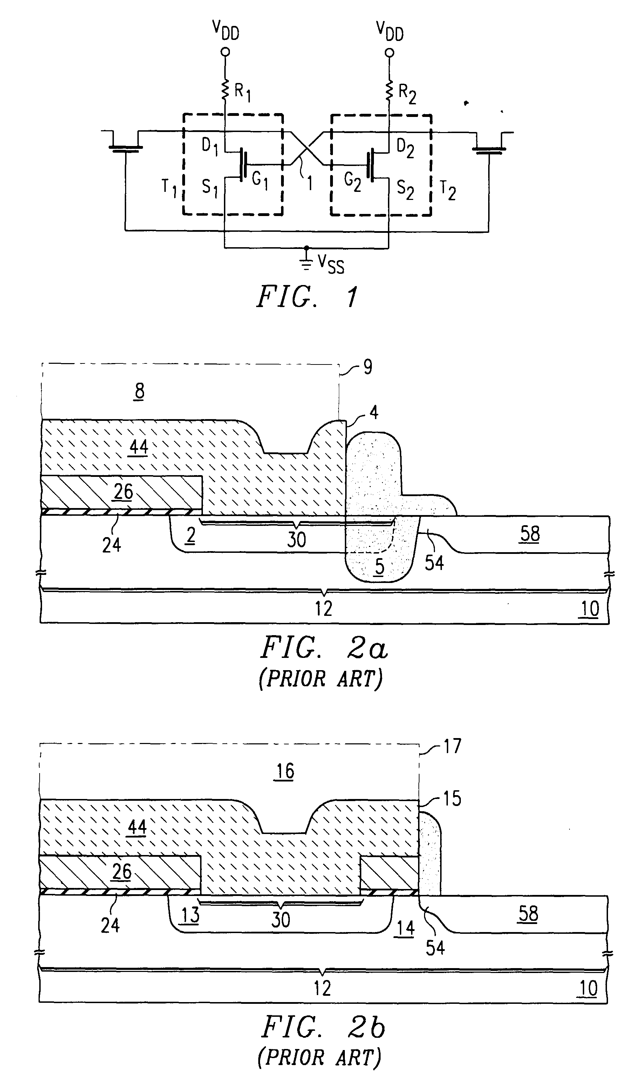

Buried contacts are often used to make the connections between the gate and the remote drain of cross-coupled transistors. This configuration is particularly useful in memory applications, such as SRAMs, shown in Figure 1. The configuration is formed by connecting the gate G₁ of the first transistor T₁ to the drain D₂ of the second transistor T₂, and the gate G₂ of the second transistor T₂ to the drain D₁ of the first transistor T₁. The gate G₁ is typically polysilicon and the drain D₂ is an implanted region of the substrate on which the transistors are formed.

The buried contact is made by implanting a region in the substrate near the drain D₂ of the second transistor, which would make the implanted region remote from the gate G₁ of the first transistor. A layer of doped polysilicon is formed over a gate oxide (or over the first polysilicon in the split-poly process) and connected to the implanted region through an opening in the gate oxide. The doped polysilicon is patterned to form the gate G₁ of the first transistor. The implanted region is then connected to the lightly doped drain (LDD) region, and thus to the drain D₂ of the second transistor.

The alignment tolerance and etch bias of the masking layer used to pattern the gate G₁ determine where the edge of the gate G₁ will be formed when the gate G₁ is patterned. The doped polysilicon layer not needed for the gate G₁ is then etched away.

A problem in the prior art, as illustrated in Figure 2a, is that the masking layer 8, shown in phantom for reference purpose, can be misaligned. The edge 9 of the masking layer used to pattern the gate is located in the range of the alignment tolerance and the etch bias of the masking layer 8 away from the edge of opening 30. Since all of the doped polysilicon 44 not needed for the gate has to be etched away, a large overetch is required. A selective etch can differentiate between dielectric and polysilicon, but not between the substrate 10 and the doped polysilicon 44, since both are silicon. Thus, a selective etch can be used that will stop on the dielectric 24, but not one that will stop on the substrate. When the masking layer 8 is perfectly aligned or misaligned such that the edge 9 of the masking layer 8, and therefore the gate edge 4, is located over the dielectric 24, the etch stops at the dielectric 24. However, when masking layer 8 is misaligned such that the edge 9 of the masking layer is located over the implanted region 2, which is substrate 10 implanted with charged ions, etching will continue through the entire overetch period, since the etch cannot differentiate between the substrate 10 and the doped polysilicon 44. Because the substrate 10 etches at about the same rate as the polysilicon 44, a large trench 5 is created in the implanted region 2. This trenching results in a smaller contact between the implanted region 2 and the LDD region 54, increasing the resistance of the buried contact and causing improper functioning of the circuit. If the trench is sufficiently large the contact between the implanted region and the LDD region may not form at all, causing an open circuit at the connection 1, shown in Figure 1, and a malfunctioning of the device in which the circuit is used. The trenching, and higher buried contact resistance caused by it, also produces leakage currents, which cause instability, improper functioning of the circuit, and an increase in power dissipation.

Referring now to Figure 2b, in order to avoid trenching enclosure rules are used that ensure that the position of the gate edge 15 is always over the dielectric 24 and that the masking layer 16 cannot be misaligned to allow the gate edge 15 to be formed above the implanted region 13. In order to avoid trenching the enclosure rules have to ensure that the edge 17 of the masking layer 16 is nominally aligned with a position on the dielectric 24 spaced at least the width of an alignment tolerance away from the edge of the opening 30. This way when the masking layer 16 is misaligned within the alignment tolerance in the direction of the opening 30 the etch would not cause trenching. However, when the masking layer is misaligned within the alignment tolerance in the direction opposite from the opening 30 the gate 15 could be up to two misalignment tolerances away from the opening, producing an area of low dopant concentration 14 between the implanted region 13 and the LDD region 54. The low dopant concentration region 14 has a higher resistance than the higher doped areas, like the LDD region 54 and the implanted region 13, thus the buried contact having the low dopant concentration region 14 would have a higher buried contact resistance than a buried contact where the LDD region 54 and the implanted region 13 are in contact with each other. The higher resistance causes improper functioning of the circuit, including a decrease in the speed of the circuit, and possibly non-functional memory. To produce a good contact between the LDD region 54 and the implanted region 13 through the low doped region requires excessive thermal cycling. However, such excessive thermal cycling can lead to lowering of the threshold voltages of pull-down and pass transistors, and the degradation of other components in the integrated circuit.

The present application discloses a method for forming a semiconductor device structure, and the semiconductor structure formed according to such a method, in which sidewall spacers are formed in the region where a buried contact is to be formed. The sidewall spacers ensure that the patterning of the gate over an implanted region to form the buried contact does not trench the region, and permit the rules for enclosure of the buried contact in the patterning of the polysilicon to form the gate to be eased enough to allow the lightly doped drain region to be formed adjacent to the implanted region. Thus a good contact, having a low resistance is formed between the lightly doped drain region and the implanted region, without the use of excessive thermal cycling to connect the lightly doped drain to the implanted region.

In the sample embodiment a gate dielectric is formed over a surface of an active area of a first conductivity type. A thin, doped, first polysilicon protective layer is formed over the gate dielectric. An opening is formed through the polysilicon, and then through the dielectric. The opening exposes a portion of the surface of the semiconducting substrate, and an implanted and/or diffused region is formed in the substrate under the opening. Sidewall spacers are formed at the edges of the opening. A second doped polysilicon is formed over the dielectric, the sidewall spacers, and the implanted region. The complete conductor (including both the first polysilicon and the polysilicon contacting the implanted region) is then patterned to form a gate. The contact of the gate and the implanted region is the buried contact.

One advantage of the present invention is that the implanted region of a buried contact is not trenched, even if the buried contact is misaligned, when the misalignment tolerance is less than the width of the sidewall spacer.

Another advantage of this invention is that the buried contact has a lower resistance.

Another advantage of this invention is that excessive thermal cycling is not required to connect the implanted region to the LDD region of the buried contact.

A further advantage of this invention is that the enclosure rules are relaxed.

Another advantage of this invention is that the density of components can be increased.

Another advantage of this invention is that reliable compact SRAM cells can be fabricated using a polycrystalline layer as the conductor layer without using metal to form contacts in this conductor layer.

A further advantage of this invention is that the above advantages are achieved utilizing conventional process flows.

Other advantages and objects of the invention will be apparent to those of ordinary skill in the art having reference to the following specification together with the drawings.

According to a first aspect of the present invention there is provided a method for forming an integrated circuit comprising forming a dielectric over an active region of first conductivity type in a semiconducting body, forming a first conductor over said dielectric, forming an opening through said first conductive layer and said dielectric exposing a portion of said active region, forming an implanted region of a second conductivity type in said semiconducting body through said exposed portion of said active region, forming sidewall spacers in said opening adjacent to edges of said opening, forming a second conductor over said dielectric, said sidewall spacers, and said implanted region, wherein said second conductor comprises a transistor gate, patterning said second conductor, and forming a lightly doped region of said second conductivity type adjacent to said implanted region.

Said sidewall spacers may have a width of at least the alignment tolerance and etch bias of a masking layer for patterning said second conductor.

An enclosure rule for patterning said second conductor may be neglible.

Said first conductor and said second conductor may comprise doped polycrystalline silicon.

Said second conductor may comprise a metal silicide.

Each said sidewall spacer may comprise an oxide.

Said first conductivity type may be P-type.

The method may further comprise a source/drain region implanted adjacent to said lightly doped region.

Said integrated circuit may be an SRAM.

According to a second aspect of the present invention there is provided a method for forming a buried contact comprising forming a dielectric over an active region formed in a semiconducting body, forming an opening through said dielectric exposing a portion of said active region, forming sidewall spacers in said opening adjacent to edges of said opening, and forming a conductor over said dielectric, and said sidewall spacers, patterning said conductor.

Said sidewall spacers may have a width of at least the alignment tolerance and etch bias of a masking layer for patterning said conductor.

An enclosure rule for patterning said conductor may be negligible.

Said step of forming said conductor may comprise forming a first conductor over said dielectric, and forming a second conductor over said first conductor, and said sidewall spacers.

Said step of forming said first conductor may be performed after said step of depositing said dielectric and before said step of forming said opening through said dielectric, and may comprise, depositing a first conductor over said dielectric, and anisotropically etching an opening through said first conductor, and said step of forming said second conductor is performed after said step of forming said sidewall spacers, and comprises depositing a second conductor over said first conductor, said sidewall spacers, and said diffusion region.

Said first conductor and said second conductor may comprise doped polycrystalline silicon of a second conductivity type.

Said second conductor may comprise a metal silicide.

Said sidewall spacers may comprise an oxide.

According to a third aspect of the present invention there is provided a method for forming a buried contact comprising forming a dielectric over an active region formed in a semiconducting body, forming an opening through said dielectric exposing a portion of said active region, forming a first diffusion region having a conductivity type in said semiconducting body under said opening, forming sidewall spacers in said opening adjacent to edges of said opening, and forming a conductor over said dielectric, said sidewall spacers, and said diffusion region, patterning said conductor, and implanting a second diffusion region of the same conductivity type as said first diffusion region to provide connection of said first diffusion region.

Said sidewall spacers may have a width of at least the alignment tolerance and etch bias of a masking layer for patterning said conductor.

An enclosure rule for patterning said conductor may be negligible.

Said step of forming said conductor may comprise forming a first conductor over said dielectric, and forming a second conductor over said first conductor, said sidewall spacers, and said first diffusion region.

Said step of forming said first conductor may be performed after said step of depositing said dielectric and before said step of forming said opening through said dielectric, and may comprise depositing a first conductor over said dielectric, and anisotropically etching an opening through said first conductor, and said step of forming said second conductor is performed after said step of forming said sidewall spacers, and comprises depositing a second conductor over said first conductor, said sidewall spacers, and said first diffusion region.

Said first conductor and said second conductor may comprise doped polycrystalline silicon of a second conductivity type.

Said second conductor may comprise a metal silicide.

Said sidewall spacers may comprise an oxide.

The method may further comprise a source/drain region diffusion adjacent to said lightly doped region.

According to a fourth aspect of the present invention there is provided a semiconductor device, comprising a dielectric overlying a surface of an active of a first conductivity type in a semiconducting body, wherein a portion of said surface is exposed through an opening through said dielectric, a diffusion region of a second conductivity type adjacent to said exposed portion of said surface of said semiconducting body, sidewall spacers adjacent to edges of said opening, a conductor overlying said dielectric, said sidewall spacers, and said diffusion region, wherein said diffusion region is in contact with a lightly doped drain region, and wherein said conductor comprises a field-effect transistor gate.

Said sidewall spacers may have a width of at least the alignment tolerance and etch bias of a masking layer for forming said conductor.

Said conductor may comprise a first conductor overlying said dielectric, and a second conductor overlying said first conductor, said sidewall spacers, and said diffusion region.

Said first conductor and second conductor may comprise doped polycrystalline silicon of a second conductivity type.

Said second conductor may comprise a metal silicide.

Said sidewall spacers may comprise an oxide.

Said first conductivity may be P-type.

The structure may further comprise a source/drain region adjacent to said lightly doped region.

According to a fifth aspect of the present invention there is provided a static random memory, comprising a dielectric overlying a surface of an active of a first conductivity type in a semiconducting body, wherein a portion of said surface is exposed through an opening through said dielectric, a first conductor overlying said dielectric, and an implanted region of a second conductivity type adjacent to said exposed portion of said surface of said semiconducting body, sidewall spacers adjacent to edges of said opening, a second conductor overlying said first conductor, said sidewall spacers, and said implanted region, wherein said implanted region is in contact with a lightly doped drain region, and wherein said second conductor comprises a field-effect transistor gate.

Said sidewall spacers may have a width of at least the alignment tolerance and etch bias of a masking layer for forming said second conductor.

Said first conductor and said second conductor may comprise doped polycrystalline silicon.

Said second conductor may comprise a metal silicide.

Said sidewall spacers may comprise an oxide.

Said first conductivity type may be P-type.

The memory may further comprise a source/drain region formed adjacent to said lightly doped region.

Some embodiments of the invention will now be described by way of example and with reference to the accompanying drawings in which:
Figure 1 is an electrical diagram, in schematic form, of a conventional SRAM cell.
Figures 2a and 2b are cross-sectional views of conventionally formed buried contacts.
Figure 3 is a cross-sectional view of an integrated circuit formed according to the present invention.
Figures 4 through 15 are cross-sectional views illustrating various steps in the fabrication of the integrated circuit in Figure 3.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

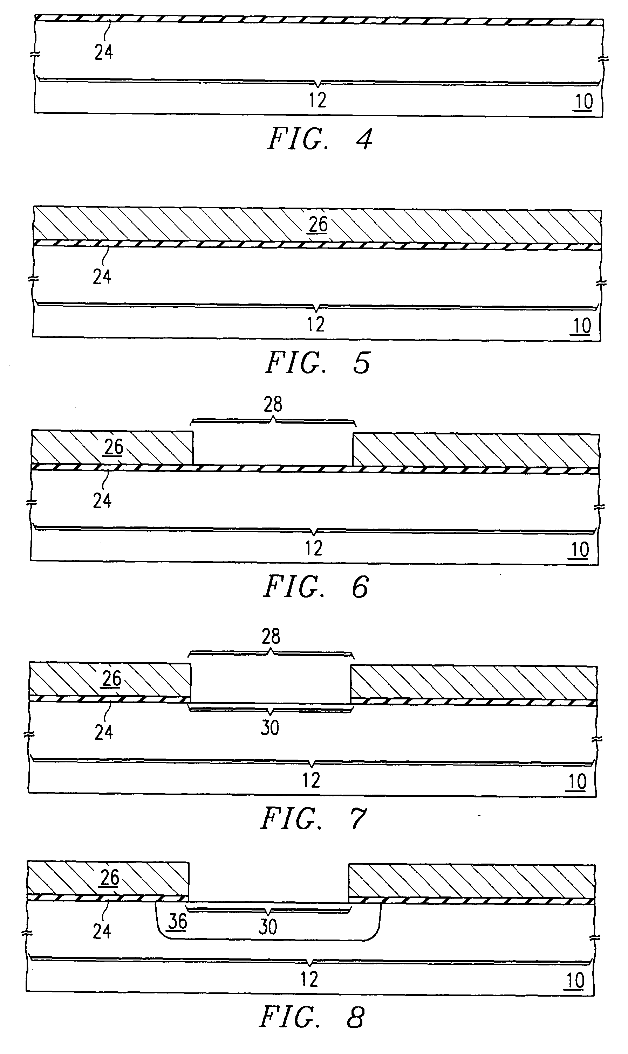

A method will now be described by which an integrated circuit can be fabricated according to the preferred embodiment of the invention. Referring to Figure 4, a thin first dielectric 24 overlies an active region 12 of a first electrical conductivity, e.g. P-type, of substrate 10. In the present preferred embodiment active region 12 is doped to achieve a concentration of about 10¹⁴/cm³. The first dielectric 24 forms the gate oxide, which is typically a conformal undoped, grown, silicon dioxide, or any other oxide known in the art, having a thickness between 60 Å and 100 Å.

Referring now to Figure 5, a thin, first conductor 26 is formed over the first dielectric 24. The first conductor 26 is preferably doped polycrystalline silicon, hereinafter first polysilicon. The doping level of the first polysilicon is typically 5x10¹⁹/cm³. The first polysilicon 26 prevents masking layers used in subsequent process steps from contacting and the first dielectric 24, i.e. the gate dielectric, thus avoiding the possibility of impurities from the masking layer entering the first dielectric 24 and damaging the electrical properties of the first dielectric 24. The first polysilicon 26 is typically between 1000 Å and 2000 Å, preferably 1500 Å thick.

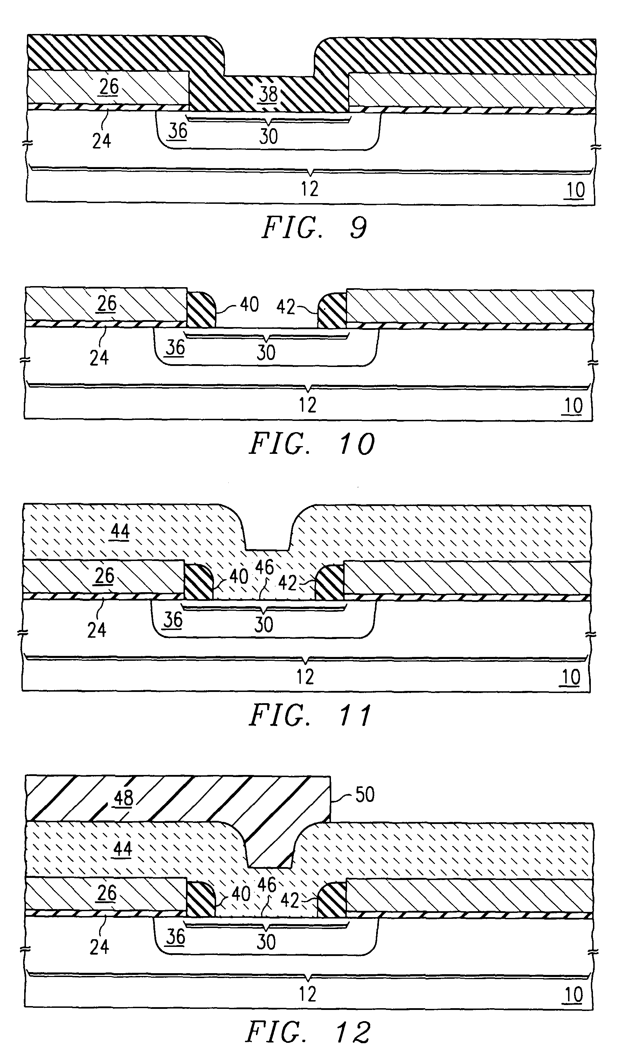

Opening 28 is etched through the first polysilicon 26 using a highly selective anisotropic etch that stops on the dielectric, as illustrated in Figure 6. Opening 28 is at least as wide as the buried contact, plus twice the alignment tolerance and etch bias of the masking layer that will be used to pattern the gate G₁ of one of the cross-coupled transistors shown in Figure 1. In modern process technology the alignment tolerance and etch bias of the masking layer is typically 800 Å. The width of the buried contact is preferably the same as a typical gate width, which is 5000 Å in modern 0.5 µ technology. As illustrated in Figure 7, the portion of the first dielectric 24 directly under the opening 28 is removed to form opening 30. Referring now to Figure 8, the substrate 10 under the opening 30 is doped with ions of a second conductivity type, e.g. N-type, typically by implanting the substrate. To form an N-type implanted region, preferably a dose of 3x10¹⁵/cm² of phosphorous at 50KeV is used, forming an implanted region 36, hereinafter implanted region, having a concentration of typically between 1x10²⁰/cm³ to 3x10²⁰/cm³.

Referring to Figure 9, a layer of second dielectric 38 is deposited over the first polysilicon 26 and implanted region 36. The second dielectric 38 is typically an oxide, conformally deposited and then anisotropically etched to form sidewall spacers 40, 42 at the edges of the opening as shown in Figure 10. The second dielectric 38 is preferably the same thickness as the first polysilicon 26, preferably 1500 Å. The sidewall spacers 40, 42 should be at least as wide as the alignment tolerance and etch bias of the masking layer used to pattern the gate, which is about 800 Å in modern process technology. The sidewall spacers are preferably 1500 Å wide.

The buried contact is formed at the junction of gate G₁ of one of the cross coupled transistors, shown in Figure 1, and the implanted region 36 remote from this gate. As illustrated in Figure 11, a second polysilicon 44, doped to achieve a second electrical conductivity, is deposited over the first polysilicon 26, the sidewall spacers 40, 42, and the portion of the implanted region 36 exposed through the opening 30. In modern process technology, the second polysilicon 44 is between 1000 Å and 2000 Å thick, preferably 1500 Å, and is doped to between 5x10¹⁹/cm³ and 5x10²⁰/cm³, preferably 1x10²⁰/cm³. The second polysilicon 44 will be patterned and etched to form the gate G₁, or any other desired local interconnect. The junction of the gate G₁ and the implanted region 36 is the buried contact 46.

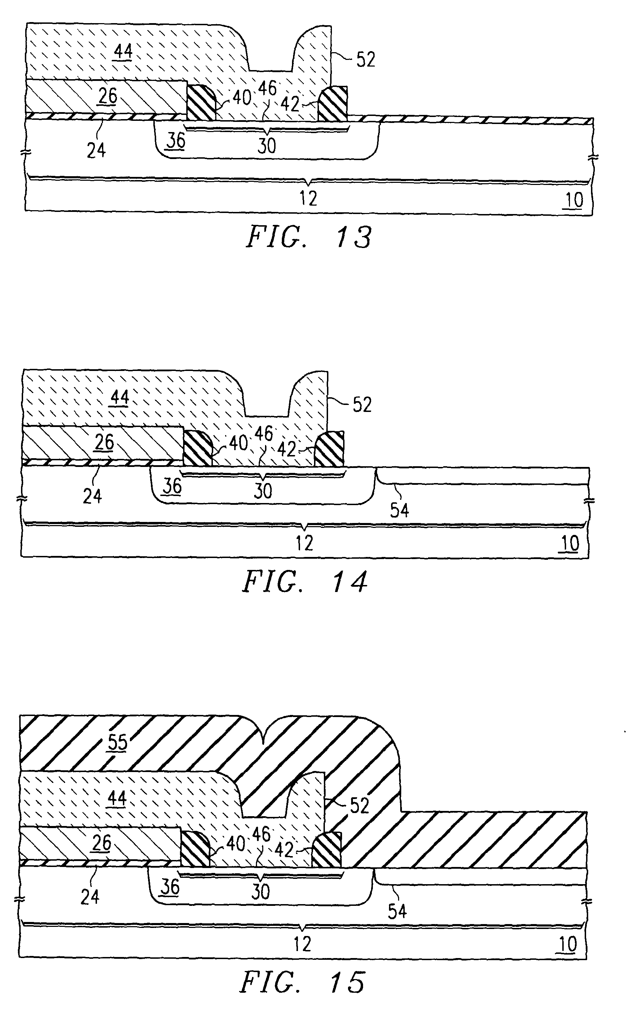

Referring now to Figure 12, a masking layer 48 is deposited on the surface of the second polysilicon 44. The edge 50 of the masking layer 48 determines the position of the gate edge 52, as illustrated in Figure 13. The second polysilicon 44 is patterned and etched, typically by highly selective anisotropic etch, such as Cl₂ and HBr etch, with an etch selectivity of greater than 100:1, chosen specifically so that the etch stops on the dielectric. Since the sidewall spacers 40, 42 are at least as wide as the misalignment tolerance and the etch bias of the masking layer 48, the edge 50 of the masking layer 48, and therefore the gate edge 52, cannot land on the exposed portion of the implanted region 36. The gate edge 52 will land on either the sidewall spacer 42 or on the first dielectric 24. Since the etch selectivity is chosen to ensure that the etch will stop on a dielectric, which is preferably an oxide, the etchback will stop when either the first dielectric 24 or the sidewall spacer 42 is reached. This prevents the trenching common in the prior art caused by the rapid etching of the silicon in the implanted region 36 during the etchback of the polysilicon gate layer, i.e. the second polysilicon 44 and the first polysilicon 26. This avoids the problems caused by trenching, including leakage currents and smaller or possibly even a complete lack of contact between the implanted region 36 and the drain region that is formed adjacent to the implanted region, which causes device instability, higher resistance in the buried contact or a complete malfunction of the transistor.

As shown in Figure 14, the masking layer is removed, the first dielectric 24 may also be removed, although the first dielectric may be left. A lightly doped drain (LDD) region 54 is formed in substrate 10 adjacent to the implanted region 36. The LDD region is typically formed by implanting the substrate 10 with phosphorous to achieve a concentration between .1x10¹⁸/cm³ and 3x10¹⁸/cm³, and a lateral diffusion length of about 500 Å after subsequent heating steps. Since the sidewall spacer 42 is at least as wide as the alignment tolerance and etch bias of the masking layer 48, the enclosure needed to ensure that the position of the gate edge 52 does not lead to trenching is zero. The edge of the masking layer can be aligned with the edge of the buried contact, i.e. the edge of opening 30. In the prior art, for a polysilicon second conductor 44, the enclosure rules should be at least the alignment tolerance of the masking layer, if a different material is used for the second conductor 44, the minimum enclosure rule may need to include the etch bias as well. In modern process technology the enclosure rules should be typically 1000 Å to 1500 Å, while as described above, un the current invention the edge masking layer can be aligned with the edge of the opening 30, thus making the enclosure zero. When the masking layer is misaligned in the direction of the opening 30, the gate edge 52 is over the sidewall spacer 42, and the edge of LDD region 54 will be connected to the implanted region 36 during the formation of the LDD region 54. When the masking layer is misaligned in the direction away from the opening 30, the gate edge will be at most one misalignment tolerance away from the opening 30. When a thermal cycle is applied to the structure, both the implanted region 36, and the LDD region 52 will diffuse toward each other and connect. Therefore, the combined lateral diffusion lengths of the implanted region and the LDD region must be at least equal to one misalignment tolerance of the masking layer at an acceptable thermal cycle. In current process technology these combined lateral diffusion lengths equal about 1000 Å.

In the prior art, in order to avoid trenching the enclosure rules had to ensure that the edge of the masking layer is aligned with a position on the dielectric 24 at least the width of one alignment tolerance plus any safety margin away from the edge of the opening. However, when the masking layer is misaligned within the alignment tolerance in the direction opposite from the opening the gate could be up to two misalignment tolerances plus the safety margin away from the opening, producing the lower doped region 14, shown in Figure 2b, where there is a lower dopant concentration region 14 between the implanted region 13 and the LDD region 54. Referring to Figure 14 and Figure 2b simultaneously, ensuring that the LDD region 54 will be formed in contact with the implanted region 36 eliminates the problem of high buried contact resistance caused by the low dopant concentration of the lower dopant region concentration 14. Also, since in the present invention the distance between the implanted region 36 and the LDD region 54 is at most one misalignment tolerance, whereas the distance between the implanted region 13 and the LDD region 54 in the prior art is at least one misalignment tolerance plus the safety margin, and can be up to two misalignment tolerances plus the safety margin, a much smaller thermal cycle is needed to produce a good contact between the implanted region and the LDD region in the present invention than in the prior art.

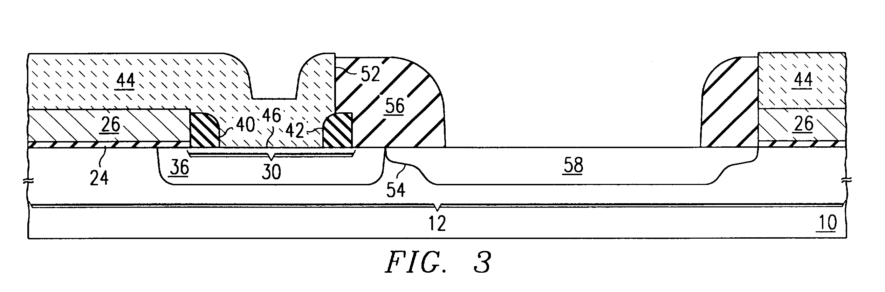

Referring now to Figure 15, a third dielectric 55 is formed over the substrate 10 and the second polysilicon 44. This third dielectric 55 is preferably a conformal undoped oxide, or any other dielectric known in the art, and is anisotropically etched back to form the sidewall spacers needed to implant the source/drains. Third dielectric 55 is typically 1200 Å thick in modern process technology. As shown in Figure 3, sidewall spacer 56 is formed adjacent to the gate edge 52. Sidewall spacer 56 is formed in a conventional way, and source/drain region 58 is conventionally implanted using sidewall spacer 56 to define the region to be implanted. The source/drain region is typically implanted with arsenic at a dosage of 3x10¹⁵/cm² and phosphorous at a dosage of 3x10¹⁴/cm², at 40KeV. The circuit is now ready for conventional further processing steps.

Referring to Figure 3 the physical construction of an integrated circuit formed according to the preferred embodiment of the present invention will now be described in detail. A dielectric 24 of conformal undoped silicon oxide, or any other oxide known in the art, overlies an active region 12, of a first electrical conductivity, e.g., P-type, of substrate 10. The properties and thickness of dielectric 24, are those needed to form a gate oxide. In modern process technology dielectric 24 is usually silicon dioxide deposited between 60 Å and 100 Å thick. A thin first conductive layer 26, typically between 1000 Å and 2000 Å, preferably 1500 Å, overlies the dielectric 24. The first conductive layer 26 is preferably polysilicon.

An opening 30 through the dielectric 24 and the first polysilicon 26 overlies an implanted region 36 of a second conductivity type, e.g., N-type. Opening 30 contains sidewall spacers 40, 42 which define the buried contact 46 between the second polysilicon 44 and the implanted region 36. Sidewall spacers 40, 42 should be at least as wide as the alignment tolerance and etch bias of the masking layer used to pattern the gate. The sidewall spacers are preferably formed of a conformal undoped oxide, or any other oxide known in the art, and are preferably 1500 Å thick.

The buried contact is the junction of the gate G₁ of one of the cross-coupled transistors, shown in Figure 1, and the drain D₂ of the other of the cross-coupled transistors remote from this gate. Referring again to Figure 3, a second polysilicon 44, doped to achieve a second electrical conductivity, overlies the first polysilicon 26, the sidewall spacers 40, 42, and the portion of the implanted region 36 exposed through the opening 30. The second polysilicon 44 is the gate G₁ of one of the cross coupled transistors. The junction of the second polysilicon 44 and the implanted region 36 is the buried contact 46.

A sidewall spacer 56 preferably of conformal undoped silicon oxide, or any other dielectric known in the art, is adjacent to the gate edge 52 of second polysilicon 44. A lightly doped drain (LDD) region 54 is adjacent to the implanted region 36, and a source/drain region 58, which is the drain D₂ of the other transistor shown in Figure 1, is adjacent to the LDD region 54.

Referring again to Figure 3, since the sidewall spacers 40, 42 are the at least as wide as the misalignment tolerance and the etch bias of the masking layer used to pattern the second polysilicon 44, the gate edge 52 cannot land on the exposed portion of the implanted region 36. The gate edge 52 will land on either the sidewall spacer 42 or on the dielectric 24. The etch selectivity is chosen to ensure that the etch will stop on a dielectric. The etchback will stop when either the dielectric 24 or the sidewall spacer 42 is reached, preventing the trenching common in the prior art caused by the rapid etching of the silicon in the implanted region 36 during the etchback of the polysilicon gate layer. This avoids the problems caused by trenching, including leakage currents and smaller or possibly even a complete lack of contact between the implanted region 36 and the drain region that is formed adjacent to the implanted region, which causes device instability, higher resistance in the buried contact or a complete malfunction of the transistor.

Additionally, because the sidewall spacer 42 is at least as wide as the alignment tolerance and etch bias of the masking layer used to pattern the second polysilicon 44, the enclosure rules needed to ensure that the position of the gate edge 52 prevents trenching can be relaxed, and the gate edge 52 is nominally aligned with the edge of the opening 30, instead of a position on the dielectric 24 at least the width of one alignment tolerance plus any safety margin away from the edge, as in the prior art. Aligning the gate edge 52 with the edge of the opening 30 reduces the amount of space required for the device and allows more devices to be fabricated in a unit area, increasing the device density per unit area. Furthermore, the alignment of the gate edge 52 with the edge of the opening 30 allows the gate edge 52 to form above the implanted region 36. Therefore, the edge of LDD region 54 will be connected to the implanted region 36, unlike the prior art in Figure 2b, where there is a lower doped region 14 between the implanted region 13 and the LDD region 52. Ensuring that the LDD region will be formed in contact with the implanted region eliminates the problem of high buried contact resistance caused by the low dopant concentration of the lower dopant concentration region 14, and reduces the thermal cycling needed to produce a good contact between the implanted region and the LDD region. This structure is particularly useful in SRAM memory cells, shown in Figure 1, and in SRAM memories, where the cross-coupled transistors are commonly used.

As will be appreciated by those skilled in the art, the process steps described above can be used with nearly any conventional process flow.

While the invention has been specifically described with reference to a preferred embodiment, it will be understood by those of ordinary skill in the prior art having reference to the current specification and drawings that various modifications may be made and various alternatives are possible therein without departing from the spirit and scope of the invention.

For example:

Although a method of forming a N-channel transistor is disclosed, one may form a P-channel transistor without departing from the scope of the invention.

While the gate is described as polysilicon, polycide, or a metal salicide, may be used.

Additionally while the sidewall spacers are described as typically silicon dioxide, other dielectrics may be used.

Furthermore, while the invention is described with relation to a 4 transistor SARM memory cell, the invention can be used in a 6 transistor SRAM memory without departing from the scope of the invention.

## Claims

1. A method for forming an integrated circuit comprising:
forming a dielectric over an active region of first conductivity type in a semiconducting body;
forming a first conductor over said dielectric;
forming an opening through said first conductive layer and said dielectric exposing a portion of said active region;
forming an implanted region of a second conductivity type in said semiconducting body through said exposed portion of said active region;
forming sidewall spacers in said opening adjacent to edges of said opening;
forming a second conductor over said dielectric, said sidewall spacers, and said implanted region, wherein said second conductor comprises a transistor gate;
patterning said second conductor; and
forming a lightly doped region of said second conductivity type adjacent to said implanted region.

2. The method of claim 1, wherein said sidewall spacers have a width of at least the alignment tolerance and etch bias of a masking layer for patterning said second conductor.

3. The method of claim 1, wherein an enclosure rule for patterning said second conductor is negligible.

4. A method for forming a buried contact comprising:
forming a dielectric over an active region formed in a semiconducting body;
forming an opening through said dielectric exposing a portion of said active region;
forming sidewall spacers in said opening adjacent to edges of said opening; and
forming a conductor over said dielectric, and said sidewall spacers;
patterning said conductor.

5. A method for forming a buried contact comprising:
forming a dielectric over an active region formed in a semiconducting body;
forming an opening through said dielectric exposing a portion of said active region;
forming a first diffusion region having a conductivity type in said semiconducting body under said opening;
forming sidewall spacers in said opening adjacent to edges of said opening; and
forming a conductor over said dielectric, said sidewall spacers, and said diffusion region;
patterning said conductor; and
implanting a second diffusion region of the same conductivity type as said first diffusion region to provide connection of said first diffusion region.

6. The method of claim 4 or claim 5, wherein said sidewall spacers have a width of at least the alignment tolerance and etch bias of a masking layer for patterning said conductor.

7. The method of claim 4 or claim 5, wherein an enclosure rule for patterning said conductor is negligible.

8. The method of claim 4 or claim 5, wherein said step of forming said conductor comprises:
forming a first conductor over said dielectric; and
forming a second conductor over said first conductor, said sidewall spacers, and said first diffusion region.

9. The method of claim 8, wherein:
said step of forming said first conductor is performed after said step of depositing said dielectric and before said step of forming said opening through said dielectric, and comprises:
depositing a first conductor over said dielectric; and
anisotropically etching an opening through said first conductor; and
said step of forming said second conductor is performed after said step of forming said sidewall spacers, and comprises:
depositing a second conductor over said first conductor, said sidewall spacers, and said first diffusion region.

10. A semiconductor device, comprising:
a dielectric overlying a surface of an active of a first conductivity type in a semiconducting body, wherein a portion of said surface is exposed through an opening through said dielectric;
a diffusion region of a second conductivity type adjacent to said exposed portion of said surface of said semiconducting body;
sidewall spacers adjacent to edges of said opening;
a conductor overlying said dielectric, said sidewall spacers, and said diffusion region;
wherein said diffusion region is in contact with a lightly doped drain region; and
wherein said conductor comprises a field-effect transistor gate.

11. A structure according to claim 10, wherein said sidewall spacers have a width of at least the alignment tolerance and etch bias of a masking layer for forming said conductor.

12. A structure according to claim 10, wherein said conductor comprises:
a first conductor overlying said dielectric; and
a second conductor overlying said first conductor, said sidewall spacers, and said diffusion region.

13. A static random memory, comprising:
a dielectric overlying a surface of an active of a first conductivity type in a semiconducting body, wherein a portion of said surface is exposed through an opening through said dielectric;
a first conductor overlying said dielectric; and
an implanted region of a second conductivity type adjacent to said exposed portion of said surface of said semiconducting body;
sidewall spacers adjacent to edges of said opening;
a second conductor overlying said first conductor, said sidewall spacers, and said implanted region;
wherein said implanted region is in contact with a lightly doped drain region; and
wherein said second conductor comprises a field-effect transistor gate.

14. A memory according to claim 13, wherein said sidewall spacers have a width of at least the alignment tolerance and etch bias of a masking layer for forming said second conductor.

15. A memory according to claim 13, wherein said first conductor and said second conductor comprise doped polycrystalline silicon.

16. A memory according to claim 13, wherein said second conductor comprises a metal silicide.
